# EUROPEAN PATENT APPLICATION

(11) **EP 4 503 136 A1**
(43) Date of publication of application: **05.02.2025**
(21) Application number: 23189335.5
(22) Date of filing: 02.08.2023
(51) Int. Cl.: H01L 29/08, H01L 29/10, H01L 29/66, H01L 29/732

(54) **BIPOLAR TRANSISTOR AND METHOD OF MAKING A BIPOLAR TRANSISTOR**

(71) Applicant: NXP B.V., 5656 AG Eindhoven (NL)
(72) Inventor: DONKERS, Johannes, 5656AG Eindhoven (NL); WERKMAN, Ronald, 5656AG Eindhoven (NL); SEBEL, Patrick, 5656AG Eindhoven (NL)
(74) Representative: Miles, John Richard

(57) **Abstract**

A method of making a bipolar transistor comprises forming an extrinsic base layer (104) over an oxide layer on a substrate. After an emitter window is opened in the extrinsic base layer, a sidewall spacer (140, 142) is formed on the sidewall of the emitter window. After forming the sidewall spacer, the oxide layer may be etched away to expose the substrate and to form a cavity extending beneath the extrinsic base layer. Subsequently, an undoped monocrystalline launcher layer (150) and a monocrystalline emitter (130) are formed in the emitter window whereby a peripheral parts of the monocrystalline layers (130, 150) fills the cavity. An anneal is then performed to form an emitter diffusion region (162) in the base layer (112) and a base link region (136) from dopants of the extrinsic base (104) that diffuse into the base layer (112) and into the peripheral parts of the monocrystalline layers (130, 150).

## Description

### FIELD

This disclosure relates to a method of making a bipolar transistor and to a bipolar transistor.

### BACKGROUND

In the manufacture of some bipolar transistors, a hydrogen sealing step is used to make a self-aligned base-emitter construction. This hydrogen sealing step may be incompatible with some process steps that might otherwise be included in the manufacturing process.

### SUMMARY

Aspects of the disclosure are set out in the accompanying independent and dependent claims. Combinations of features from the dependent claims may be combined with features of the independent claims as appropriate and not merely as explicitly set out in the claims.

According to an aspect of this disclosure, there is provided a method of making a bipolar transistor, the method comprising:
providing a semiconductor substrate having a major surface and one or more layers located beneath the major surface for forming a base of the bipolar transistor;
forming an oxide layer on the major surface to cover a part of the one or more layers for forming the base;
forming an extrinsic base layer over the oxide layer and at least a part of the major surface located at the periphery of the oxide layer;
forming a nitride layer on the extrinsic base layer;
forming an emitter window of the bipolar transistor by removing a part of the nitride layer and the extrinsic base layer to reveal the oxide layer, wherein at least a peripheral part of the oxide layer remains covered by the extrinsic base layer and the nitride layer;
forming a sidewall spacer on a side wall of the emitter window;
after forming the sidewall spacer, etching away the oxide layer to expose the one or more layers for forming the base, wherein the etching away of the oxide layer leaves a cavity, corresponding to the location of the peripheral part of the oxide layer, beneath the extrinsic base layer;
forming a monocrystalline emitter in the emitter window, wherein a peripheral part of the monocrystalline emitter at least partially fills the cavity; and
annealing to:
   form an emitter diffusion region in an uppermost layer of the one or more layers located beneath the major surface, wherein the emitter diffusion region comprises first dopants which diffuse into the uppermost layer from the monocrystalline emitter; and
   form a base link region from second dopants which diffuse into the uppermost layer from the extrinsic base layer.

In some embodiments, at least part of the monocrystalline emitter located in the cavity is converted by the diffusion of the second dopants into a part of the base link region.

In some embodiments, prior to the annealing, the extrinsic base layer is more highly doped than the part of the monocrystalline emitter located in the cavity.

In some embodiments, prior to the annealing, the monocrystalline emitter comprises:
a substantially undoped launcher layer covering the major surface of the substrate inside the emitter window; and
a doped emitter region located on top of the launcher layer.

In some embodiments the method comprises growing the launcher layer and the doped emitter region in a single epitaxial step.

In some embodiments, the first dopants have a first conductivity type, and the second dopants have a second conductivity type. In some embodiments, the first dopants comprise Arsenic (As) and the second dopants comprise Boron (B).

In some embodiments, the one or more layers located beneath the major surface comprise:
the uppermost layer; and
a doped layer located directly beneath the uppermost layer.

In some embodiments, the uppermost layer comprises silicon and the doped layer located directly beneath the uppermost layer comprises SiGe:C.

In some embodiments, following the annealing, the doped layer located directly beneath the uppermost layer remains substantially free of the first and/or second dopants.

In some embodiments, the extrinsic base layer comprises SiGe.

In some embodiments, the extrinsic base layer comprises amorphous silicon.

In some embodiments, the sidewall spacer comprises an oxide layer and a nitride layer substantially covering the oxide layer.

In some embodiments, the sidewall spacer defines a lateral spacing between the base link region and the emitter diffusion region.

In some embodiments, the method does not include a hydrogen sealing step.

In some embodiments, the method further comprises forming an amorphous emitter portion located on the monocrystalline emitter in the emitter window.

In some embodiments, the base link region comprises a first portion and a second portion. The first portion may be thicker than the second portion. The first portion may be located at a portion corresponding to the cavity beneath the extrinsic base layer.

According to another aspect of this disclosure, there is provided a bipolar transistor manufactured according to the method set out above.

### BRIEF DESCRIPTION OF THE DRAWINGS

Embodiments of the present disclosure will be described hereinafter, by way of example only, with reference to the accompanying drawings in which like reference signs relate to like elements and in which:
Figures 1 to 5 show a series of steps for making a bipolar transistor;
Figures 6 to 9 show a series of steps for making a bipolar transistor in accordance with an embodiment of this disclosure;
Figure 10 shows a detail of the step shown in Figure 8; and
Figure 11 shows a detail of the step shown in Figure 9.

### DETAILED DESCRIPTION

Embodiments of the present disclosure are described in the following with reference to the accompanying drawings.

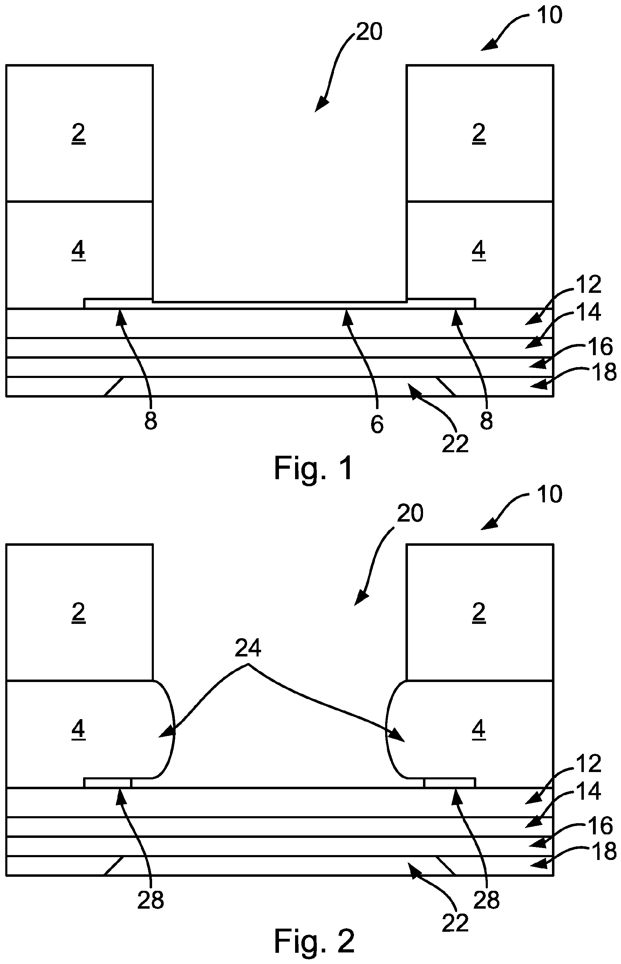

Figures 1 to 5 show a series of steps for making a bipolar transistor 10. As will be described below, the series of steps shown in Figures 1 to 5 includes a hydrogen sealing step, which is generally incompatible with certain process options that might otherwise be used. Examples of such process options include the use of amorphous silicon for the extrinsic base layer and the use of SiGe for the extrinsic base layer instead of pure silicon.

In Figure 1, there is provided a semiconductor substrate that includes a number of layers.

The layer 18 is a collector layer, which may be provided with additional implants 22 to create a locally higher doped collector part. The collector layer may be an epitaxially grown layer.

The layers 12, 14, 16 form a base stack. In this example, the layers 12, 16 comprise silicon (Si) and the layer 14 comprises SiGe:C. The layers 12, 14, 16 may be formed epitaxially. The layers 12, 14, 16 are for forming a base stack of the bipolar transistor, including an extrinsic region of the base. The layer 12 in this example is located at a major surface of the substrate, with the layer 14 located (e.g., immediately) below the layer 12, the layer 16 located (e.g., immediately) below the layer 14, and the layer 18 located (e.g., immediately) below the layer 16.

In Figure 1, the substrate has also been processed to include a number of features built up on the major surface of the substrate. A layer of oxide 6 is located on the major surface. The layer of oxide 6 may, for instance, be formed using TEOS. An extrinsic base layer 4 is deposited over the layer of oxide 6. Note that the extrinsic base layer 4 extends laterally beyond the peripheral edges of the layer of oxide 6 so that some parts of the extrinsic base layer 4 are located directly upon the major surface. The extrinsic base layer 4 comprises polysilicon. This will allow subsequent formation of a base link region of the bipolar transistor. A layer of nitride 2 (typically silicon nitride) is formed on the extrinsic base layer 4.

After the formation of the layer of oxide 6 the extrinsic base layer 4 and the layer of nitride 2, an emitter window 20 is formed through the layer of nitride 2 and the extrinsic base layer 4 using an etching process. During this etching process, the layer of oxide 6 acts as an etch stop to protect the underlying layers 12, 14, 16. Note that the emitter window 20 is dimensioned (using a mask) such that at least a peripheral parts 8 of the layer of oxide 6 remains covered by the extrinsic base layer 4 and the nitride layer 2.

Turning now to Figure 2, an etching step may next be used to remove the layer of oxide 6, including the peripheral parts 8. Thereafter, a hydrogen (H₂) sealing step is used to seal the cavities left by the removal of the peripheral parts 8 of the layer of oxide 6. This causes the formation of regions 28 from the migration of some of the material of the extrinsic base layer 4 into the cavities. Typically, this would partially, but not entirely, fill the cavities. The hydrogen sealing step generally also causes the inner side walls of the extrinsic base layer 4 to bulge inwards toward the center of the emitter window 20. Neither the partial filling of the cavities nor the bulging inward of the extrinsic base layer 4 is ideal because the former makes it difficult to control the subsequent lateral distance between the base link region 36 and the emitter diffusion 34, while the latter makes it difficult to control the dimensions of the emitter window 20.

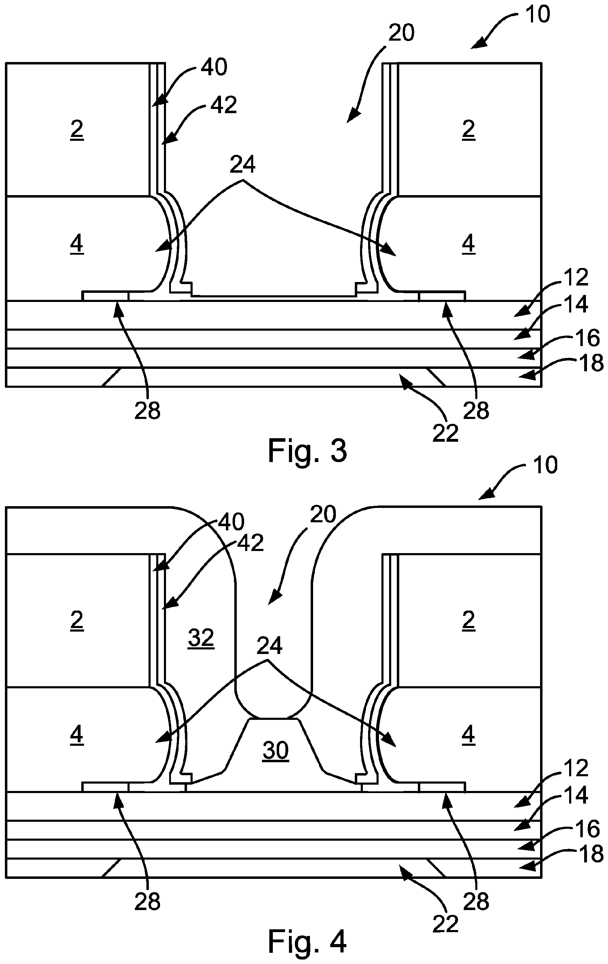

Turning now to Figure 3, after the hydrogen sealing step, a sidewall spacer is formed on the sidewall of the emitter window 20. The sidewall spacer includes an oxide layer 40 and a nitride later 42. Note that the oxide layer 40 also re-covers the major surface of the substrate with oxide and fills the parts of the cavities beneath the extrinsic base layer 4 which were not back filled during the hydrogen sealing step described above. After the formation of the nitride layer 42, the part of the oxide layer 40 that covers the major surface (not including the parts located within the remnants of the cavities) are removed with a selective etch.

Turning now to Figure 4, an emitter is now formed inside the emitter window. The emitter includes monocrystalline portion 30 and an amorphous portion 32. The emitter may be epitaxially grown. The monocrystalline portion 30 covers the major surface of the substrate and consequently is in direct contact with the layer 12. The amorphous portion 32 covers the sidewalls of the emitter window 20 and contacts the monocrystalline portion 30. Note that the side wall spacers insulate the extrinsic base layer 4 from the emitter.

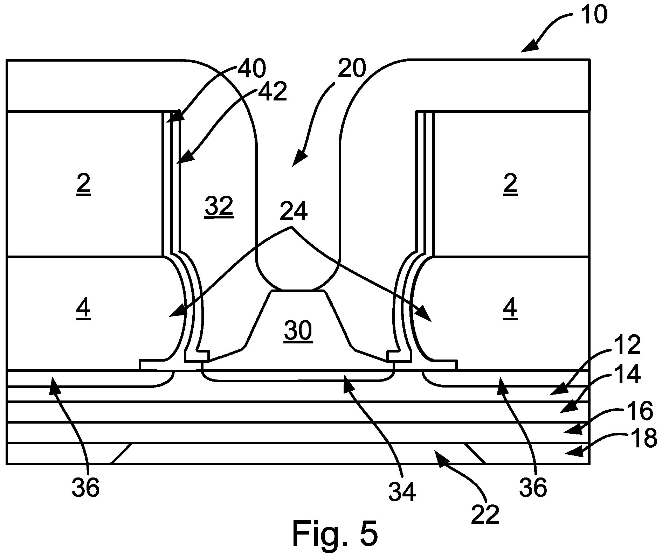

Turning now to Figure 5, an annealing step is now performed. The aim of the annealing step is to form a base link region 36 and an emitter diffusion 34. In particular, the base link region 36 is located at the interface between the extrinsic base layer 4 and the layer 12 by the diffusion of dopants from the extrinsic base layer 4 into the layer 12, while the emitter diffusion 34 is located in a part of the layer 12 immediately beneath the monocrystalline portion 30 of the emitter by the diffusion of dopants from the monocrystalline portion 30 into the layer 12. The dopants from the extrinsic base layer 4 and the monocrystalline portion 30 of the emitter may, for instance, be Boron (B) and Arsenic (As), respectively.

The process shown in Figures 1 to 5 has a number of disadvantages.

For instance, as already noted, the use of the hydrogen sealing step makes it difficult to control the subsequent lateral distance between the base link region 36 and the emitter diffusion 34. This is because the lateral size of the regions 28 is generally not well defined, whereby the subsequent lateral extent of the base link regions 36 is also difficult to control. As also already noted, the bulging of the extrinsic base layer 4 makes it difficult to control the dimensions of the emitter window 20.

Moreover, the use of the hydrogen sealing step is incompatible with the use of some materials other than polysilicon for the extrinsic base layer 4. For instance, amorphous silicon cannot be used because amorphous silicon shows much less surface diffusion, making it more difficult to seal the cavities left by the removal of the peripheral parts 8 of the layer of oxide 6, as described above. Also, the use of SiGe for the extrinsic base layer instead of pure silicon is not possible because the surface diffusion is much bigger for this material and this would exacerbate the bulging problem noted above.

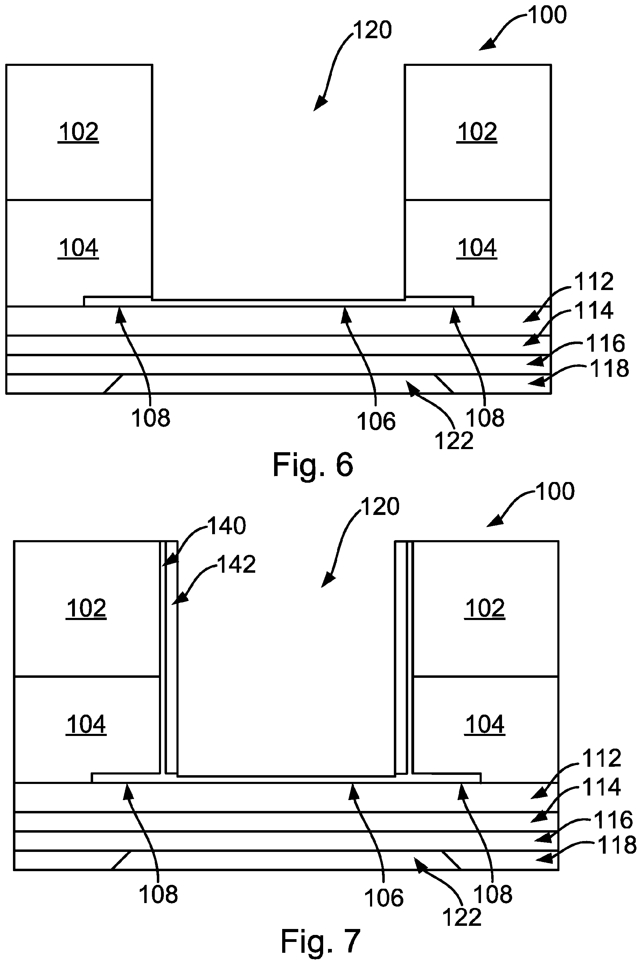

Figures 6 to 9 show a series of steps for making a bipolar transistor 100 in accordance with an embodiment of this disclosure.

The processing shown in Figure 6 may be substantially the same as that described above in relation to Figure 1. Thus, in Figure 6, there is provided a semiconductor substrate. The substrate may be a silicon substrate. The substrate has a major surface. The substrate includes one or more layers located beneath the major surface for forming a base of the bipolar transistor 100. In this embodiment, these layers include a layer 112, a layer 114 and a layer 116. The layers 112, 114, 116 form a base stack. The layer 112 is an uppermost layer of the base stack, which may be located at the major surface of the substrate. The layer 116 is a lowermost layer of the base stack. Intervening layers such as the layer 114 may be located inbetween the uppermost layer 112 and the lowermost layer 116. In this embodiment, the layer 114 is located (e.g., immediately) below the layer 112, and the layer 116 is located (e.g., immediately) below the layer 114. In this embodiment, the layers 112, 116 may comprise silicon. In this embodiment, the layer 114 may be doped. For instance, the layer 114 may comprise SiGe:C. The uppermost layer 112 may be undoped (comprising, e.g., Si). The lowermost layer 116 may also be undoped (comprising, e.g., Si). It will be appreciated that alternative layer compositions could be used. The layers 112, 114, 116 may be formed epitaxially.

In addition to the above-mentioned layer(s), there may be provided features for forming a collector of the bipolar transistor 100. In the present embodiment, these features include a collector layer 118, which may be provided with additional implants 122 to create a locally higher doped collector part. The collector layer 118 may be an epitaxially grown layer. In this vertical device layout, the collector is located beneath the base of the bipolar transistor 100, while the emitter will be formed above the base. In this embodiment, the collector layer 118 is located immediately beneath the lowermost layer 116 in the base stack.

In Figure 6, as with Figure 1, the substrate has also been processed to include a number of features built up on the major surface of the substrate. A layer of oxide 106 is located on the major surface. The layer of oxide 106 may, for instance, be formed using TEOS. An extrinsic base layer 104 is deposited over the layer of oxide 106. Note that the extrinsic base layer 104 extends laterally beyond the peripheral edges of the layer of oxide 106 so that some parts of the extrinsic base layer 104 are located directly upon the major surface. The extrinsic base layer 104 may comprise polysilicon. Note that unlike the example of Figures 1 to 5, instead of polysilicon, the extrinsic base layer 104 may comprise amorphous silicon and may also comprise SiGe instead of pure silicon (nevertheless, it is envisaged that polysilicon might be used in some embodiments). The extrinsic base layer 104 will subsequently allow the formation of the base link region 136 to be described below. The extrinsic base layer 104 may be doped with second dopants (e.g., B), as will be described in more detail below. A layer of nitride 102 (for instance, silicon nitride) may be formed on the extrinsic base layer 104.

After the formation of the layer of oxide 106 the extrinsic base layer 104 and the layer of nitride 102, an emitter window 120 is formed through the layer of nitride 102 and the extrinsic base layer 104 using an etching process. During this etching process, the layer of oxide 106 acts as an etch stop to protect the underlying layers 112, 114, 116. Note that the emitter window 120 may be dimensioned (e.g., using a mask) such that at least a peripheral part 108 of the layer of oxide 106 remains covered by the extrinsic base layer 104 and the nitride layer 102.

Turning now to Figure 7, in a next step, which departs from the process described above in relation to Figures 1 to 5, a sidewall spacer is formed on the sidewall of the emitter window 120. The sidewall spacer may include a plurality of layers. These layers serve to insulate the extrinsic base layer 104 from the subsequently formed emitter and also to allow close control of the lateral width of the emitter window 120. In this embodiment, the sidewall includes an oxide layer 140 and a nitride layer 142.

Note that the sidewalls are formed with the layer of oxide 106 in situ and that no hydrogen sealing step has been performed at least at the time that the sidewall spacer is formed. This allows the lateral extent of the cavities which will be formed by the subsequent removal of the layer of oxide 106 to remain well controlled. Moreover, in the absence of a hydrogen sealing step, the aforementioned bulging of the extrinsic base layer 104 does not occur. Because of this, the lateral extent of the emitter window 120 remains well defined. Accordingly, materials such as amorphous silicon and/or SiGe may be used for the extrinsic base layer 104.

After the sidewall spacer has been formed, the layer of oxide 106, including the peripheral part 108, may be removed using an etching process (e.g., a HF dip). This exposes the underlying layers 112, 114, 116 for forming the base stack and, in particular, the uppermost layer 112. The etching away of the layer of oxide 106, including the peripheral part 108, also leaves a cavity beneath the extrinsic base layer 104. The location of the cavity corresponds to the location of the peripheral part 108 of the layer of oxide 106.

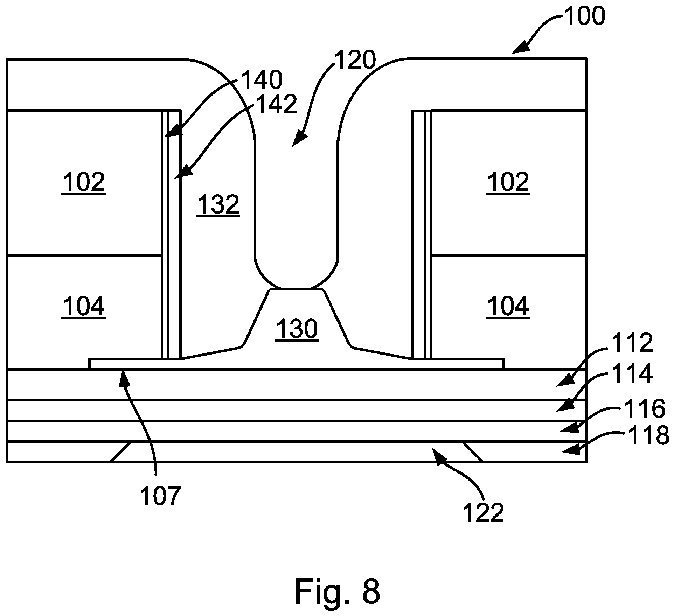

Turning now to Figure 8, in a next step, an emitter is formed within the emitter window 120. The emitter includes a monocrystalline emitter 130. The emitter may also include an amorphous portion 132, which may be located on top of the monocrystalline emitter 130. The emitter may be grown epitaxially. As will be described in more detail below, the monocrystalline emitter 130 may be doped with first dopants (e.g., As). The monocrystalline emitter 130 covers the major surface of the substrate and consequently is in direct contact with the uppermost layer 112. The amorphous portion 132 covers the sidewalls of the emitter window 120 and contacts the monocrystalline emitter 130. Note that the side wall spacer insulates the extrinsic base layer 104 from the emitter.

As can be seen in Figure 8, a peripheral part 107 of the monocrystalline emitter 130 at least partially fills the cavity beneath the extrinsic base layer 104 formed by the removal of the layer of oxide 106 (in particular, the peripheral part 108). The monocrystalline emitter 130 may, as also shown in Figure 8, include a central bulge, which extends upwardly from the surface of the substrate toward the top of the emitter window.

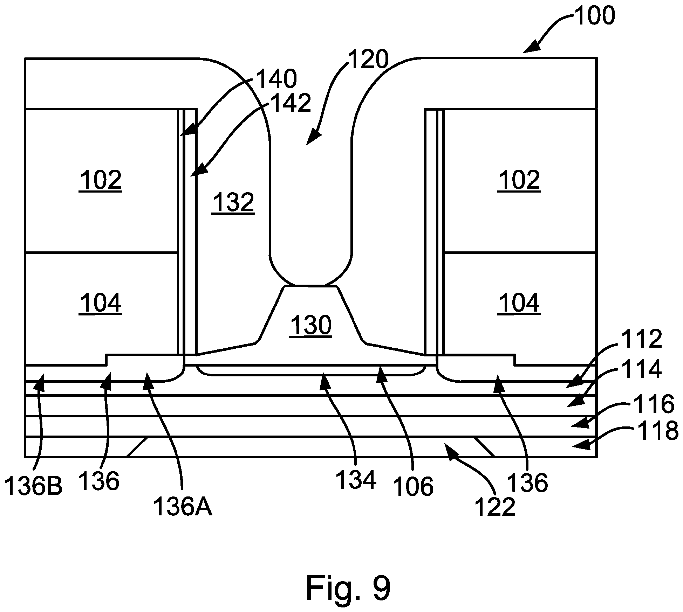

An annealing step may now be performed, which may result in a structure of the kind shown in Figure 9.

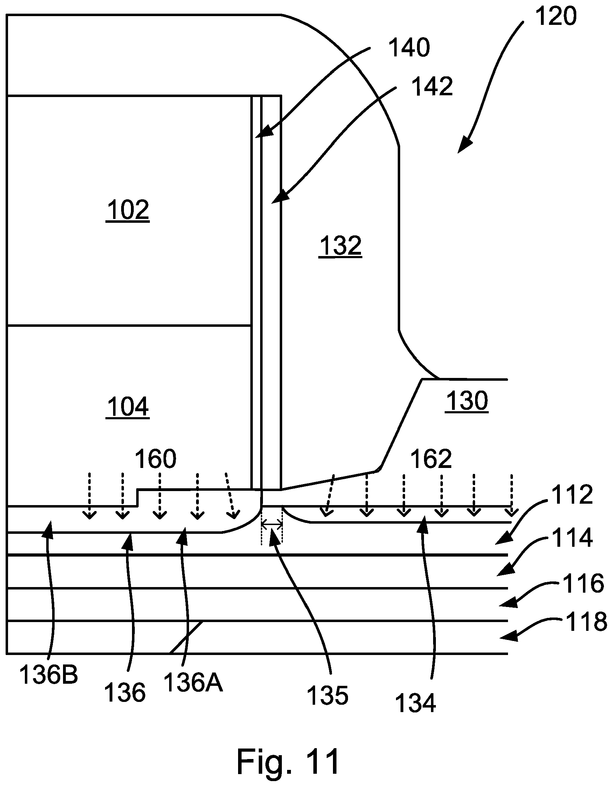

As can be seen in Figure 9, the annealing step leads to the formation of an emitter diffusion region 134 in an uppermost layer 112. The emitter diffusion region 134 is located directly beneath the monocrystalline emitter 130 and comprises first dopants (e.g., As) having a first conductivity type, which diffuse into the uppermost layer 112 from the monocrystalline emitter 130 during the annealing process. The emitter diffusion region 134 may extend partially through the uppermost layer 112. The diffusion path 162 of the first dopants for forming the emitter diffusion region 134 is illustrated in Figure 11.

When viewed from above the major surface of the substrate, emitter diffusion region 134 may substantially fill the area defined by the emitter window. The lateral edge of the emitter diffusion region 134 may thus be defined by the lateral extent of the sidewall spacer within the emitter window.

As can be seen in Figure 9, the annealing step also leads to the formation of a base link region 136. The base link region 136 may be located between the extrinsic base layer 104 and the uppermost layer 112. The base link region 136 may comprise second dopants (e.g., B) having a second conductivity type, which diffuse into the uppermost layer 112 from the extrinsic base layer 104 during the annealing process. Note that the second conductivity type may be different to the first conductivity type. In the embodiment described here, the first conductivity type is n-type, while the second conductivity type is p-type, although it will be appreciated that other doping types are possible.

As shown in Figure 9, the base link region 136 may comprise a thicker portion 136A (corresponding to the location of the peripheral part 107 of the monocrystalline emitter 130 in Figure 8) and a thinner portion 136B (corresponding to the positions located laterally beyond the thicker portion). Note that, at the thicker portion 136A, the diffusion of the second dopants into the uppermost layer 112 may require those dopants to travel via the peripheral part 107 of the monocrystalline emitter 130 shown in Figure 8. Some of these dopants remain within the peripheral part 107 of the monocrystalline emitter 130 in the cavity beneath the extrinsic base layer 104 during the diffusion process, which has the effect of converting the peripheral part 107 of the monocrystalline emitter 130 into part of (the thicker portion 136A of) the base link region 136. The diffusion path 160 of the second dopants for forming the base link region 136 is illustrated in Figure 11.

As can also be seen from Figures 9 and 11, following the annealing process, the doped layer 114 located directly beneath the uppermost layer 112 may remain substantially free of the first and/or second dopants. The diffusion process described above may thus result in a base link region 136 and an emitter diffusion region 134 which extend into, but not completely through the uppermost layer 112.

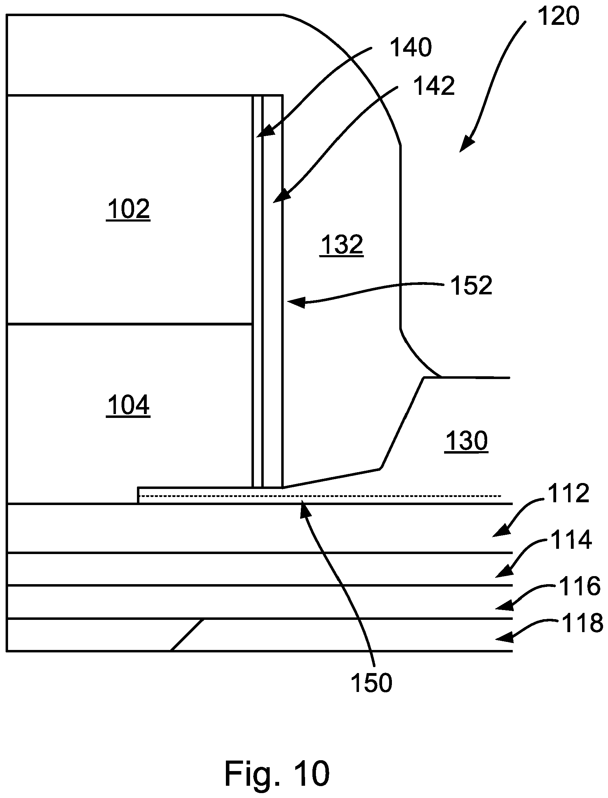

Turning now to Figure 10, further details regarding the formation of the base link region 136 and the emitter diffusion region 134 will now be described.

As shown in Figure 10, the formation of the monocrystalline emitter 130 may include first depositing (e.g., epitaxially) a thin, substantially undoped launcher layer 150 covering the major surface of the substrate inside the emitter window 120. The thickness of the launcher layer 150 may be chosen such that it occupies at least a lower region of the cavity beneath the extrinsic base layer 104. For instance, the thickness of the launcher layer 150 may be approximately half the height of the cavity beneath the extrinsic base layer 104. In other embodiments, the launcher layer 150 may completely fill the cavity. Thereafter, the remainder of the monocrystalline emitter 130 may be deposited on top of the launcher layer 150. As noted above, the remainder of the monocrystalline emitter 130 may be relatively highly doped with the first dopants (e.g., As). Accordingly, the thickness of the launcher layer 150 may be defined by the height of the cavity beneath the extrinsic base layer 104, which is itself defined by the thickness of (the peripheral part 108 of) the layer of oxide 106 described above. In some embodiments, the thickness of the launcher layer 150 may be around 10-15nm.

Although the launcher layer 150 is substantially undoped, it is envisaged that the launcher layer 150 may nevertheless have a background concentration (e.g., <4E17 at/cm³) of the second dopants (e.g., B). During the above-described diffusion process, the second dopants, which diffuse into and through the peripheral part 107 of the monocrystalline emitter 130 from the extrinsic base layer 104 may generally overwhelm these background level dopants, allowing the peripheral part 107 of the monocrystalline emitter 130 (including the parts of the launcher layer 150 in the cavity) to be converted into a part of (the thicker portion 136A of) the base link region 136. For comparison, the concentration of second dopants (e.g., B) in the extrinsic base layer 104 may be around 1E20 at/cm³, which is far higher than the background concentration of first dopants in the launcher layer 150 (<4E17 at/cm³). Accordingly, the presence of the undoped launcher layer 150 within the cavity, which at least partially prevents the (highly doped) remainder of the monocrystalline emitter 130 from forming within the cavity, assists in allowing the second dopants to overwhelm the first dopants when forming the thicker portion 136A of the base link region 136.

In some embodiments, the launcher layer 150 and the remaining doped part of the monocrystalline emitter 130 may be formed using a single epitaxial step, which simplifies the manufacturing process.

As noted above, the lateral edge of the emitter diffusion region 134 may be defined by the lateral extent of the sidewall spacer within the emitter window 120. Also, the lateral dimensions of the layers of the sidewall spacer may assist in defining the lateral extent of the base link region (although it is acknowledged that some of the second dopants may creep beneath the sidewall spacer (e.g., beneath the oxide layer 140) during the diffusion process). Accordingly, the lateral spacing 135 (see Figure 11) between the base link region 136 and the emitter diffusion region 134 may, to at least some extent, be defined by the sidewall spacer. Accordingly, the methods described herein allow for self-aligned formation of the base link region 136 and the emitter diffusion region 134 in a manner that allows for close control of the lateral spacing 135.

According to an embodiment of this disclosure, there may be provided a bipolar transistor manufactured according to methods of the kind described above in relation to Figures 6-11.

Accordingly, there has been described a method of making a bipolar transistor comprises forming an extrinsic base layer over an oxide layer on a substrate. After an emitter window is opened in the extrinsic base layer, a sidewall spacer is formed on the sidewall of the emitter window. After forming the sidewall spacer, the oxide layer may be etched away to expose the substrate and to form a cavity extending beneath the extrinsic base layer. Subsequently, a monocrystalline emitter is formed in the emitter window whereby a peripheral part of the monocrystalline emitter fills the cavity. An anneal is then performed to form an emitter diffusion region and a base link region of the bipolar transistor.

Although particular embodiments of the disclosure have been described, it will be appreciated that many modifications/additions and/or substitutions may be made within the scope of the claims.

## Claims

1. A method of making a bipolar transistor, the method comprising:
providing a semiconductor substrate having a major surface and one or more layers located beneath the major surface for forming a base of the bipolar transistor;
forming an oxide layer on the major surface to cover a part of the one or more layers for forming the base;
forming an extrinsic base layer over the oxide layer and at least a part of the major surface located at the periphery of the oxide layer;
forming a nitride layer on the extrinsic base layer;
forming an emitter window of the bipolar transistor by removing a part of the nitride layer and the extrinsic base layer to reveal the oxide layer, wherein at least a peripheral part of the oxide layer remains covered by the extrinsic base layer and the nitride layer;
forming a sidewall spacer on a side wall of the emitter window;
after forming the sidewall spacer, etching away the oxide layer to expose the one or more layers for forming the base, wherein the etching away of the oxide layer leaves a cavity, corresponding to the location of said peripheral part of the oxide layer, beneath the extrinsic base layer;
forming a monocrystalline emitter in the emitter window, wherein a peripheral part of the monocrystalline emitter at least partially fills the cavity; and
annealing to:
form an emitter diffusion region in an uppermost layer of the one or more layers located beneath the major surface, wherein the emitter diffusion region comprises first dopants which diffuse into the uppermost layer from the monocrystalline emitter; and
form a base link region from second dopants which diffuse into the uppermost layer from the extrinsic base layer.

2. The method of claim 1, wherein at least part of the monocrystalline emitter located in the cavity is converted by the diffusion of the second dopants into a part of the base link region.

3. The method of claim 1 or claim 2, wherein prior to the annealing, the monocrystalline emitter comprises:
a substantially undoped launcher layer covering the major surface of the substrate inside the emitter window; and
a doped emitter region located on top of the launcher layer.

4. The method of claim 3, comprising growing the launcher layer and the doped emitter region in a single epitaxial step.

5. The method of any preceding claim, wherein the first dopants have a first conductivity type, and wherein the second dopants have a second conductivity type.

6. The method of claim 5, wherein the first dopants comprise As and wherein the second dopants comprise B.

7. The method of any preceding claim, wherein the one or more layers located beneath the major surface comprise:
said uppermost layer; and
a doped layer located directly beneath the uppermost layer.

8. The method of claim 7, wherein the uppermost layer comprises silicon and wherein the doped layer located directly beneath the uppermost layer comprises SiGe:C.

9. The method of claim 7 or claim 8, wherein following the annealing, the doped layer located directly beneath the uppermost layer remains substantially free of said first and/or second dopants.

10. The method of any preceding claim, wherein the extrinsic base layer comprises SiGe.

11. The method of any preceding claim, wherein the extrinsic base layer comprises amorphous silicon.

12. The method of any preceding claim, wherein the sidewall spacer comprises an oxide layer and a nitride layer substantially covering the oxide layer.

13. The method of any preceding claim, wherein the sidewall spacer defines a lateral spacing between the base link region and the emitter diffusion region.

14. The method of any preceding claim, wherein the method does not include a hydrogen sealing step.

15. A bipolar transistor manufactured according to the method of any preceding claim.

## Amended claims

### Amended claims in accordance with Rule 137(2) EPC.

1. A method of making a bipolar transistor (100), the method comprising:
providing a semiconductor substrate having a major surface and one or more layers (112, 114, 116) located beneath the major surface for forming a base of the bipolar transistor;
forming an oxide layer (106) on the major surface to cover a part of the one or more layers for forming the base;
forming an extrinsic base layer (104) over the oxide layer and at least a part of the major surface located at the periphery of the oxide layer;
forming a nitride layer (102) on the extrinsic base layer;
forming an emitter window (120) of the bipolar transistor by removing a part of the nitride layer and the extrinsic base layer to reveal the oxide layer, wherein at least a peripheral part (108) of the oxide layer remains covered by the extrinsic base layer and the nitride layer;
forming a sidewall spacer on a side wall of the emitter window;
after forming the sidewall spacer, etching away the oxide layer to expose the one or more layers for forming the base, wherein the etching away of the oxide layer leaves a cavity, corresponding to the location of said peripheral part of the oxide layer, beneath the extrinsic base layer;
forming a monocrystalline emitter (130) in the emitter window, wherein a peripheral part (107) of the monocrystalline emitter at least partially fills the cavity, and wherein the monocrystalline emitter comprises:
a substantially undoped launcher layer (150) covering the major surface of the substrate inside the emitter window; and
a doped emitter region located on top of the launcher layer; and annealing to:
form an emitter diffusion region (134) in an uppermost layer (112) of the one or more layers located beneath the major surface, wherein the emitter diffusion region comprises first dopants (162) which diffuse into the uppermost layer from the monocrystalline emitter; and
form a base link region (136) from second dopants (160) which diffuse into the launcher layer and the uppermost layer from the extrinsic base layer.

2. The method of claim 1, wherein at least part of the monocrystalline emitter located in the cavity is converted by the diffusion of the second dopants into a part of the base link region.

3. The method of claim 1 or claim 2, comprising growing the launcher layer and the doped emitter region in a single epitaxial step.

4. The method of any preceding claim, wherein the first dopants have a first conductivity type, and wherein the second dopants have a second conductivity type.

5. The method of claim 4, wherein the first dopants comprise As and wherein the second dopants comprise B.

6. The method of any preceding claim, wherein the one or more layers located beneath the major surface comprise:
said uppermost layer (112); and
a doped layer (114) located directly beneath the uppermost layer.

7. The method of claim 6, wherein the uppermost layer comprises silicon and wherein the doped layer located directly beneath the uppermost layer comprises SiGe:C.

8. The method of claim 6 or claim 7, wherein following the annealing, the doped layer located directly beneath the uppermost layer remains substantially free of said first and/or second dopants.

9. The method of any preceding claim, wherein the extrinsic base layer comprises SiGe.

10. The method of any preceding claim, wherein the extrinsic base layer comprises amorphous silicon.

11. The method of any preceding claim, wherein the sidewall spacer comprises an oxide layer (140) and a nitride layer (142) substantially covering the oxide layer.

12. The method of any preceding claim, wherein the sidewall spacer defines a lateral spacing (135) between the base link region and the emitter diffusion region.

13. The method of any preceding claim, wherein the method does not include a hydrogen sealing step.
